# EUROPÄISCHE PATENTSCHRIFT

(11) **EP 3 521 841 B1**
(45) Veröffentlichungstag und Bekanntmachung des Hinweises auf die Patenterteilung: **02.06.2021**
(21) Anmeldenummer: 19151252.4
(22) Anmeldetag: 10.01.2019
(51) Int. Cl.: G01R 27/16, H02H 3/40, G01R 19/25, G01R 31/08, H02H 7/26, H02H 1/00, H02H 1/04, H02H 3/05

(54) **VERFAHREN ZUM AUSLÖSEN EINES EINE ZONE ÜBERWACHENDEN DISTANZSCHUTZRELAIS**
METHOD FOR TRIPPING A ZONE MONITORED BY A DISTANCE PROTECTION RELAY
PROCÉDÉ DE DÉCLENCHEMENT D'UN RELAIS DE PROTECTION DE DISTANCE SURVEILLANT UNE ZONE

(30) Priorität: 11.01.2018 AT 500132018
(43) Veröffentlichungstag der Anmeldung: 07.08.2019
(73) Patentinhaber: Sprecher Automation GmbH, 4020 Linz (AT)
(72) Erfinder: Kleemann, Michael, 12524 Berlin (DE)
(74) Vertreter: Hübscher & Partner Patentanwälte GmbH

(56) Entgegenhaltungen:
- WO-A1-2010/006632
- DE-A1- 2 237 854
- DE-A1- 19 920 654
- US-A1- 2006 067 095

## Beschreibung

Die Erfindung bezieht sich auf ein Verfahren zum Auslösen eines eine Zone überwachenden Distanzschutzrelais bei dem in vorgegebenen Zeitschritten je ein Leitungsimpedanzwert bestimmt wird.

Distanzschutzrelais werden in Stromversorgungsnetzen eingesetzt, um im Fehlerfall eine selektive Abschaltung eines betroffenen Leitungsabschnittes zu ermöglichen. Um hierzu den Fehlerort möglichst genau bestimmen zu können, muss die Leitungsimpedanz durch Strom- und Spannungsmessung exakt ermittelt werden (WO 2010048972 A1). Die Spannungsmessung erfolgt dabei häufig über induktive Spannungswandler, da diese dem oberseitigen Spannungsverlauf sehr gut folgen können und somit ein gutes Übertragungsverhalten aufweisen. Mit größer werdender Spannung sind induktive Spannungswandler jedoch auf Grund des damit verbundenen Anstiegs der Baugröße zunehmend unwirtschaftlicher einzusetzen. Daher werden zur Spannungsmessung in Spannungsbereichen über 100 kV bevorzugt kapazitive Spannungswandler (CVT - Capacitive Voltage Transformers) verwendet, die jedoch den gravierenden Nachteil besitzen, dass sie im Fehlerfall starken transienten Übergangseffekten unterliegen und daher die Fehlerortbestimmung beeinträchtigen. Damit weisen CVTs ein deutlich schlechteres Übertragungsverhalten als induktive Spannungswandler auf.

Um den Einsatz von CVTs als Spannungswandler für Distanzschutzrelais dennoch zu ermöglichen, ist es aus dem Stand der Technik bekannt, eine fest vorgegebene Zeitspanne zwischen dem Eintreten eines Leitungsfehlers und dem Abklingen sämtlicher transienter Übergangseffekten zu warten. Nachteiligerweise verstreicht bei dieser Methode wertvolle Zeit bis zu einer Auslösung des Distanzschutzrelais. Des Weiteren wird in der US20080239602A1 vorgeschlagen, transiente Effekte durch rekursive Filter zu kompensieren. Allerdings erfordert diese Art der Kompensation hohe Rechenleistungen und führt zu vergleichsweise langen Einschwingzeiten. Daneben ist aus dem Stand der Technik bekannt, durch Anwendung inverser Übertragungsfunktionen das Übertragungsverhalten zu verbessern, wozu allerdings exakte mathematische Modelle vonnöten sind, die eine genaue Kenntnis über den eingesetzten CVT und das eingesetzte Verfahren zur Bestimmung der Leitungsimpedanz voraussetzen.

Aus dem Stand der Technik sind überdies Distanzschutzanordnungen zum Überwachen einer elektrischen Energieübertragungsleitung bekannt, wobei zumindest zwei Distanzschutzrelais Daten miteinander austauschen, um insbesondere die Zonen automatisch einstellen zu können (WO 2009095040 A1).

Es sind auch Verfahren bekannt, wobei ein Distanzschutz mithilfe sogenannter Delta-Größen gesteuert wird (JP 2008187825 A). Die Delta-Größen stellen dabei Änderungen dar, welche Strom und Spannung beim Übergang vom normalen in den fehlerbehafteten Zustand erfahren. Die Delta-Größen werden in der komplexen Ebenen ausgewertet und daraus einmalig pro Fehlerereignis eine Änderung der Leitungsimpedanz bestimmt. Über die Leitungsimpedanzänderung wird dann der Zonenentscheid gesteuert.

Darüber hinaus zeigt die DE 19920654 A1 Verfahren zur Bestimmung eines Leitungsimpedanz-Grenzwertes, die WO 2010006632 A1 Verfahren zum Erzeugen eines Fehlersignals bei Schutzgeräten sowie die US 2006067095 A1 Systeme und Verfahren, bei denen die Veränderungsrate des Impedanzvektors stabile oder instabile Pendelungen anzeigt und hierauf baiserend eine Blockierung der Distanzschutzfunktion erfolgt.

Distanzschutzrelais, bei denen zwischen einem dynamischen Verhalten und einem Verhalten in eingeschwungenem Zustand unterschieden werden muss, sind zudem aus der DE 2237854 A1 bekannt.

Der Erfindung liegt somit die Aufgabe zugrunde, ein Verfahren zu schaffen, das trotz des Einsatzes eines Spannungswandlers mit einem ungünstigen Übertragungsverhalten vor dem Abklingen von transienten Übergangseffekten eine zuverlässige Fehlerortsbestimmung ermöglicht.

Die Erfindung löst die gestellte Aufgabe dadurch, dass jedem Zeitschritt der Änderungsbetrag eines Änderungsvektors zwischen dem zum jeweiligen Zeitschritt und dem zum jeweils vorangegangen Zeitschritt bestimmten Leitungsimpedanzwert sowie ein aus dem zum jeweiligen Zeitschritt bestimmten Leitungsimpedanzwert und einem Zonengrenzimpedanzwert ermittelter Änderungsbetragsgrenzwert zugeordnet wird und, wenn eine vorgegebene Anzahl von je einem Zeitschritt zugeordneten Änderungsbeträgen unterhalb des dem jeweiligen Zeitschritt zugeordneten Änderungsbetragsgrenzwertes liegt, der Leitungsimpedanzwert des letzten Zeitschrittes zur Erzeugung eines Auslösesignals in Abhängigkeit des Zonengrenzimpedanzwertes ausgegeben wird.

Dem erfindungsgemäßen Verfahren liegt die Erkenntnis zugrunde, dass die Änderungsbeträge der Änderungsvektoren während des Abklingens der transienten Übergangseffekte nach Eintreten der meisten Leitungsfehler mit der Zeit abnehmen, wodurch eine Abschätzung des Fortschritts der transienten Übergangseffekte ermöglicht wird, ohne dass hierfür ein mathematisches Modell des Übertragungsverhaltens des Spannungswandlers benötigt wird. Zu diesem Zweck wird der Leitungsimpedanzwert in vorgegebenen Zeitschritten in für den Fachmann bekannter Weise bestimmt, in dem üblicherweise die Momentanwerte von Strom und Spannung gemessen und daraus der komplexe Leitungsimpedanzwert ermittelt wird. Für jeden Zeitschritt wird daraufhin der Änderungsbetrag als vektorieller Betrag des Änderungsvektors zwischen dem jeweiligen und dem jeweils vorangegangen komplexen Leitungsimpedanzwert bestimmt. Daneben wird für jeden Zeitschritt ein Änderungsbetragsgrenzwert bestimmt, und zwar unter Berücksichtigung des für das jeweilige Distanzschutzrelais vorgegebenen Zonengrenzimpedanzwertes und des zum jeweiligen Zeitschritt ermittelten Leitungsimpedanzwertes. Das Verhältnis dieser beiden Werte zueinander lässt einen Rückschluss darauf zu, wie nahe ein etwaiger Leitungsfehler an der Grenze der überwachten Zone liegt. Der Änderungsbetragsgrenzwert wird daher derart bestimmt, dass dieser abnimmt, je näher ein etwaiger Leitungsfehler an der Grenze der überwachten Zone liegt, und dass dieser zunimmt, je weiter ein etwaiger Leitungsfehler von der Grenze der überwachten Zone entfernt ist und damit klar innerhalb der Zone liegt. Sobald eine vorgegebene Anzahl von je einem Zeitschritt zugeordneten, vorzugsweise unmittelbar aufeinanderfolgenden Änderungsbeträgen unterhalb des dem jeweiligen Zeitschritt zugeordneten Änderungsbetraggrenzwertes liegt, kann für die meisten Leitungsfehler davon ausgegangen werden, dass die transienten Übergangseffekte des Spannungswandlers soweit abgeklungen sind, dass mit hinreichender Sicherheit bestimmt werden kann, ob der Leitungsfehler innerhalb oder außerhalb der überwachten Zone aufgetreten ist, und zwar unabhängig davon, welcher Spannungswandler zur Messung und welches Verfahren zur Ermittlung der komplexen Leitungsimpedanzwerte verwendet wird. Hierzu wird jener Leitungsimpedanzwert herangezogen, der zu dem Zeitschritt bestimmt wurde, zu dem die vorgegebene Anzahl an unter dem jeweiligen Änderungsbeteagsgrenzwerten liegenden Änderungsbeträgen erreicht wurde. Diese Anzahl kann vorzugsweise zwischen 3 und 5 liegen. Das Auslösesignal selbst kann ebenfalls in für den Fachmann bekannter Weise aus dem Verhältnis zwischen dem Leitungsimpedanzwert und dem Zonengrenzimpedanzwert abgeleitet werden. Um den Einfluss von Offsetfehlern hierbei möglichst ausschließen zu können, wird erfindungsgemäß vorgeschlagen, dass Auslösesignal lediglich auf Basis der Reaktanz, also des imaginären Anteils des Leitungsimpedanzwertes und des Zonengrenzimpedanzwertes zu bestimmen. Zufolge der erfindungsgemäßen Maßnahmen kann damit bereits vor dem Abklingen transienter Übergangseffekte ein zuverlässiges Auslösesignal ausgegeben werden, auf Basis dessen das Distanzschutzrelais den zugeordneten Leistungsschalter auslöst.

Da insbesondere die Leitungsimpedanz bei nahe an der Zonengrenze auftretender Leitungsfehler für die Erzeugung eines korrekten Auslösesignals genau bestimmt werden muss, wird vorgeschlagen, dass der Änderungsbetragsgrenzwert für einen Zeitschritt mit kleiner werdenden Abstand zwischen dem Leitungsimpedanzwert und dem Zonengrenzimpedanzwert abnimmt. Infolgedessen wird der Leitungsimpedanzwert für das Auslösesignal bei Leitungsfehlern nahe an der Zonengrenze erst dann herangezogen, wenn die transienten Übergangseffekte bereits stark abgeklungen sind. Besonders günstige Auslösebedingungen ergeben sich in diesem Zusammenhang, wenn der Änderungsbetragsgrenzwert ein vorgegebenes Minimum bei einem Verhältnis zwischen dem Leitungsimpedanzwert und dem Zonengrenzimpedanzwert um 1 erreicht und von diesem minimalen Wert linear bei größer oder kleiner werdenden Verhältnis bis zu einem vorgegebenen Maximalwert ansteigt. Auf diese Weise kann ein Distanzschutzrelais zur Durchführung des erfindungsgemäßen Verfahrens mit besonders wenigen Parametern konfiguriert werden.

Das vorgeschlagene Verfahren eignet sich zwar für viele Leitungsfehlerarten, jedoch führen Lichtbögen zu Änderungsbeträgen, die nicht oder erst zu einem sehr späten Zeitpunkt aufeinanderfolgend unter den ermittelten Änderungsbetragsgrenzwerten liegen. Um die Bildung von Lichtbögen frühzeitig erkennen zu können, wird vorgeschlagen, dass jedem Zeitschritt die Änderungsrate des Winkels des Änderungsvektors zugeordnet wird und, wenn die Änderungsrate eine vorgegebene Lichtbogenwinkeländerungsrate übersteigt, ein Auslösesignal ausgegeben wird. Da die Änderungsrate des Winkels des Änderungsvektors bei Lichtbögen typischerweise dem Zufallsprinzip folgt und dadurch von herkömmlichen Leitungsfehlern, bei denen der Winkel des Änderungsvektors im Wesentlichen konstant bleibt, unterschieden werden können, kann ein Lichtbogen zuverlässig erkannt und der betroffene Leitungsabschnitt unverzüglich abgeschaltet werden.

In der Zeichnung ist der Erfindungsgegenstand beispielsweise dargestellt.

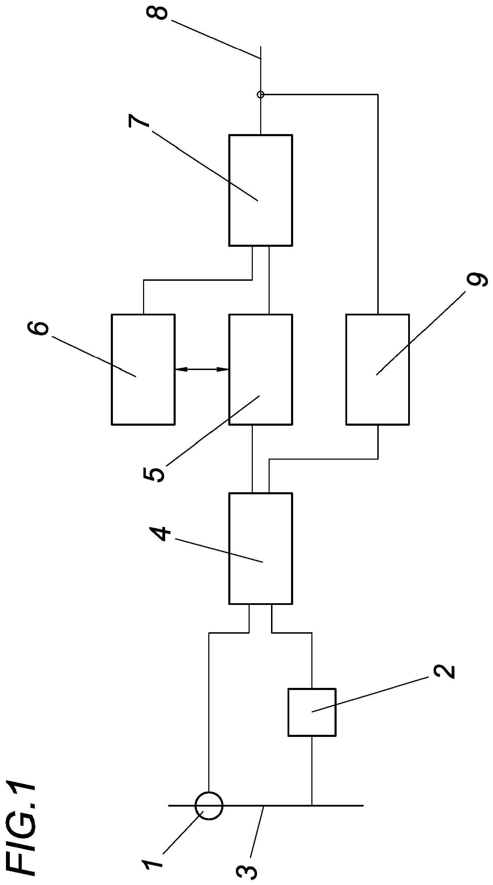

Es zeigen
- Fig. 1: eine schematische Darstellung eines Distanzschutzrelais zur Durchführung des erfindungsgemäßen Verfahrens in einem Blockschaltbild,
- Fig. 2: ein Diagramm eines beispielweisen Zusammenhangs zwischen dem Änderungsbetragsgrenzwert und dem Verhältnis zwischen dem Leitungsimpedanzwert und dem Zonengrenzimpedanzwert und
- Fig. 3: den zeitlichen Verlauf der Änderungsbeträge und des Änderungsbetragsgrenzwertes ebenfalls in einem Diagramm.

Ein Distanzschutzrelais zur Durchführung des erfindungsgemäßen Verfahrens umfasst einen Stromwandler 1 und einen Spannungswandler 2 zur Messung von momentanen Strom und Spannungswerten einer Stromleitung 3. Aus den gemessenen Strom- und Spannungswerten wird zu vorgegebenen Zeitschritten je ein Leitungsimpedanzwert bestimmt, und zwar mittels einer Impedanzmesseinrichtung 4. Die einzelnen Leitungsimpedanzwerte werden einem Stabilitätsmonitor 5 übergeben, der den jeweiligen Leitungsimpedanzwert in einem Speicher 6 ablegt um zunächst den Änderungsbetrag des Änderungsvektors zwischen dem zum jeweiligen Zeitschritt und dem jeweils vorangegangenen Zeitschritt bestimmten Leitungsimpedanzwert zu bilden und diesen ebenfalls im Speicher 6 zu hinterlegen. Daneben wird im Stabilitätsmonitor 5 für jeden Zeitschritt ein aus dem Leitungsimpedanzwert zum jeweiligen Zeitschritt und einem vorgegeben Zonengrenzimpedanzwert ermittelter Änderungsbetragsgrenzwert bestimmt, der ebenfalls im Speicher 6 hinterlegt und dem zugehörigen Änderungsbetrag, der zum gleichen Zeitschritt bestimmt wurde, zugeordnet wird.

Der Speicher 6 wird von einer Auslöseeinheit 7 abgefragt, die jeweils für eine vorgegebene Anzahl von Änderungsbeträgen des Speichers 6 überprüft, ob diese unterhalb der zugehörigen Änderungsbetragsgrenzwerte liegen, die ebenfalls im Speicher 6 abgelegt sind. Trifft dies zu, so bestimmt die Auslöseeinheit 7 auf Basis des letzten Leitungsimpedanzwertes, der zu diesem Zweck vom Stabilitätsmonitor 5 übergeben wird und dem vorgegebenen Zonengrenzimpedanzwert die geschätzte Lage des Leitungsfehlers und gibt ein Auslösesignal 8 für den zugeordneten Leistungsschalter aus, sofern der Leitungsfehler innerhalb der überwachten Zone liegt.

Um Leitungsfehler frühzeitig zu erkennen, die auf der Bildung von Lichtbögen beruhen, kann das Distanzschutzrelais eine Überwachungseinheit 9 aufweisen, die zu jedem Zeitschritt die Änderungsrate des Winkels des Änderungsvektors bestimmt und vorzeitig ein Auslösesignal 8 ausgibt, wenn die Änderungsrate eine vorgegebene Lichtbogenwinkeländerungsrate übersteigt.

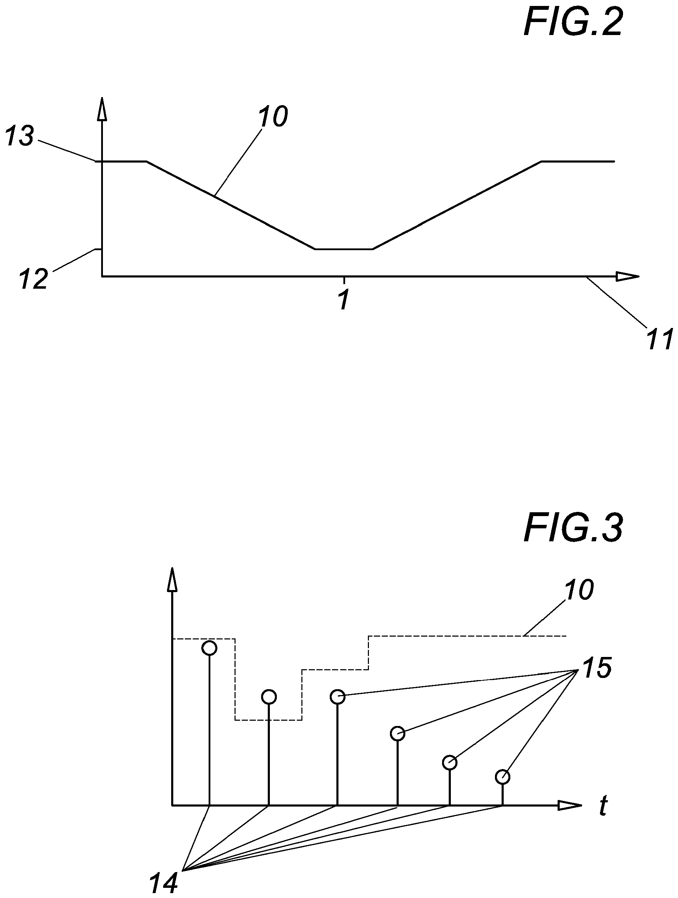

In der Fig. 2 ist das Verhältnis zwischen dem Änderungsbetragsgrenzwert 10 und dem Verhältnis 11 zwischen dem Leitungsimpedanzwert und dem Zonengrenzimpedanzwert schematisch dargestellt. Dabei steigt der Änderungsbetragsgrenzwert 10 von einem Minimalwert 12 bei einem Verhältnis 11 um 1 beidseits linear bis zu einem Maximalwert 13 an. Dementsprechend ändert sich der Änderungsbetragsgrenzwert 10 in mehreren aufeinanderfolgenden Zeitschritten 14, wenn sich das Verhältnis 11 zwischen dem Leitungsimpedanzwert und dem Zonengrenzimpedanzwert ebenfalls ändert, wie dies beispielsweise in der Fig. 3 gezeigt ist. Erst wenn eine vorgegebene Anzahl von Änderungsbeträgen 15 unterhalb des jeweiligen Änderungsbetragsgrenzwertes 10 liegt, wird über die Auslöseeinheit 7 ein Auslösesignal 8 ausgegeben.

## Patentansprüche

1. Verfahren zum Auslösen eines eine Zone überwachenden Distanzschutzrelais bei dem in vorgegebenen Zeitschritten je ein Leitungsimpedanzwert bestimmt wird, wobei jedem Zeitschritt der Änderungsbetrag eines Änderungsvektors zwischen dem zum jeweiligen Zeitschritt und dem zum jeweils vorangegangen Zeitschritt bestimmten Leitungsimpedanzwert sowie ein aus dem zum jeweiligen Zeitschritt bestimmten Leitungsimpedanzwert und einem Zonengrenzimpedanzwert ermittelter Änderungsbetragsgrenzwert (10) zugeordnet wird und, wenn eine vorgegebene Anzahl von je einem Zeitschritt zugeordneten Änderungsbeträgen unterhalb des dem jeweiligen Zeitschritt zugeordneten Änderungsbetragsgrenzwertes (10) liegt, der Leitungsimpedanzwert des letzten Zeitschrittes zur Erzeugung eines Auslösesignals (8) in Abhängigkeit des Zonengrenzimpedanzwertes ausgegeben wird.

2. Verfahren nach Anspruch 1, **dadurch gekennzeichnet, dass** der Änderungsbetragsgrenzwert (10) für einen Zeitschritt mit kleiner werdenden Abstand zwischen dem Leitungsimpedanzwert und dem Zonengrenzimpedanzwert abnimmt.

3. Verfahren nach einem der Ansprüche 1 bis 2, **dadurch gekennzeichnet, dass** jedem Zeitschritt die Änderungsrate des Winkels des Änderungsvektors zugeordnet wird und, wenn die Änderungsrate eine vorgegebene Lichtbogenwinkeländerungsrate übersteigt, ein Auslösesignal (8) ausgegeben wird.

## Claims

1. Method of activating a distance protection relay which monitors a zone, in which in each case a line impedance value is determined in specified time steps, wherein each time step is allocated the change amount of a change vector between the line impedance value determined with respect to the respective time step and the line impedance value determined with respect to the respectively preceding time step, as well as a change amount limit value (10) which is ascertained from the line impedance value determined with respect to the respective time step and from a zone limit impedance value and, if a specified number of change amounts allocated to each time step is below the change amount limit value (10) allocated to the respective time step, the line impedance value of the last time step is output in dependence upon the zone limit impedance value for generating an activation signal (8).

2. Method as claimed in claim 1, **characterised in that** the change amount limit value (10) for a time step decreases as the distance between the line impedance value and the zone limit impedance value becomes smaller.

3. Method as claimed in any one of claims 1 to 2, **characterised in that** each time step is allocated the rate of change of the angle of the change vector and, if the rate of change exceeds a specified electric arc angle rate of change, an activation signal (8) is output.

## Revendications

1. Procédé pour déclencher un relais de protection de distance surveillant une zone par lequel une valeur d'impédance de ligne est déterminée à incréments temporels prédéfinis, dans lequel à chaque incrément temporel est associé le montant de variation du vecteur de variation entre la valeur d'impédance de ligne déterminée à l'incrément temporel concerné et celle déterminée à l'incrément temporel précédent ainsi qu'une valeur limite de montant de variation (10) déterminée à partir de la valeur d'impédance de ligne déterminée à l'incrément temporel concerné et d'une valeur d'impédance de limite de zone et, quand un nombre prédéfini de montants de variation associés à un incrément temporel sont inférieurs à la valeur limite de montant de variation (10) associée à l'incrément temporel concerné, la valeur d'impédance de ligne du dernier incrément temporel est émise pour générer un signal de déclenchement (8) en fonction de la valeur d'impédance de limite de zone.

2. Procédé selon la revendication 1, **caractérisé en ce que** la valeur limite de montant de variation (10) diminue pour un incrément temporel présentant un écart en baisse entre la valeur d'impédance de ligne et la valeur d'impédance de limite de zone.

3. Procédé selon une des revendications 1 et 2, **caractérisé en ce qu'**à chaque incrément temporel est associé le taux de variation de l'angle du vecteur de variation et que, quand le taux de variation dépasse un taux de variation d'angle d'arc électrique prédéfini, un signal de déclenchement (8) est émis.
